# EUROPEAN PATENT SPECIFICATION

(11) **EP 4 264 665 B1**
(45) Date of publication and mention of the grant of the patent: **25.11.2026**
(21) Application number: 21907465.5
(22) Date of filing: 06.12.2021
(51) Int. Cl.: H10W 74/10

(54) **FET CONSTRUCTION WITH COPPER PILLARS OR BUMP DIRECTLY OVER THE FET**
FET-KONSTRUKTION MIT KUPFERSÄULEN ODER HÖCKERN DIREKT ÜBER DEM FET
CONSTRUCTION DE FET AVEC PILIERS OU BOSSE DE CUIVRE DIRECTEMENT SUR LE FET

(30) Priority: 16.12.2020 US 202017124485
(43) Date of publication of application: 25.10.2023
(73) Proprietor: Texas Instruments Incorporated, Dallas, TX 75265 (US)
(72) Inventor: JAIN, Manoj Kumar, Plano, TX 75025 (US)
(74) Representative: Zeller, Andreas
(86) International application number: PCT/US2021/061949
(87) International publication number: WO 2022/132472

(56) References cited:
- DE-A1- 102011 010 362
- US-A1- 2007 085 204
- US-A1- 2012 018 868
- US-A1- 2015 171 039

## Description

This disclosure relates to the field of semiconductor devices. More particularly, this disclosure relates to fabrication processes for semiconductor devices.

### BACKGROUND

An integrated circuit may contain a top metal layer which serves as a connection between the semiconductor device and a metal pillar, copper post, or copper bump used to connect the semiconductor device to a package. Typically, a metal pad or some other type of under bump metal (UBM) is used to provide a base on which to connect the metal pillar, post or bump which has a negative impact on die area. Typical methods may use two or three photolithography steps to pattern a top metal layer, pattern a bond pad to connect the UBM to the top metal layer, and finally a photolithography step to define the UBM layer. Methods to reduce the die area for metal pillar formation and methods to reduce the number of photolithography steps for metal pillar formation are needed. US 2007/085204 A1 discloses a semiconductor device including at least one macro-cell device, the macro-cell device comprising a plurality of LDMOS devices.

### SUMMARY

The invention is defined by the features of the appended claims. The present disclosure introduces a method of forming a semiconductor device with a metal pillar overlapping a first top metal interconnect and a second top metal interconnect. The metal pillar overlapping the first top metal interconnect and second top metal interconnect is connected to the first top metal interconnect by top metal vias while the second top metal interconnect is free of a direct electrical connection to the metal pillar.

Top metal vias are used to connect an under bump metal (UBM) to the top metal interconnect level in at least one embodiment. A stress relief layer between the protective dielectric layer and the metal pillar is used in at least one embodiment.

In accordance with one embodiment, the metal pillars are attached directly to an array of top metal vias without a bond pad of metal. The elimination of the bond pad layer reduces the mask count, processing, and cost of the device. In addition, the elimination of the bond pad results in reduced die area requirements for the metal pillar array.

These and other features of the present invention will be more readily apparent from the detailed description set forth below taken in conjunction with the accompanying drawings.

### BRIEF DESCRIPTION OF THE VIEWS OF THE DRAWINGS

FIG. 1 is a flow diagram illustrating an example method for forming a semiconductor device in accordance with one or more aspects of the present disclosure.
FIG. 2A through FIG. 2H are cross sections of a semiconductor device not forming part of the invention as claimed, depicted in various stages of an example method of formation.
FIG. 3A through FIG. 3C are views of a semiconductor device according to the invention, wherein a first top interconnect layer connected to a first metal pillar which overlaps but does not connect to a second top interconnect layer, and a second top interconnect layer connected to a second copper pillar which overlaps but does not connect to the first top interconnect layer.

### DETAILED DESCRIPTION OF EXAMPLE EMBODIMENTS

The present disclosure is described with reference to the attached figures. The figures are not drawn to scale and they are provided merely to illustrate the disclosure. Several aspects of the disclosure are described below with reference to example applications for illustration. It should be understood that numerous specific details, relationships, and methods are set forth to provide an understanding of the disclosure. The present disclosure is not limited by the illustrated ordering of acts or events, as some acts may occur in different orders and/or concurrently with other acts or events. Furthermore, not all illustrated acts or events are required to implement a methodology in accordance with the present disclosure.

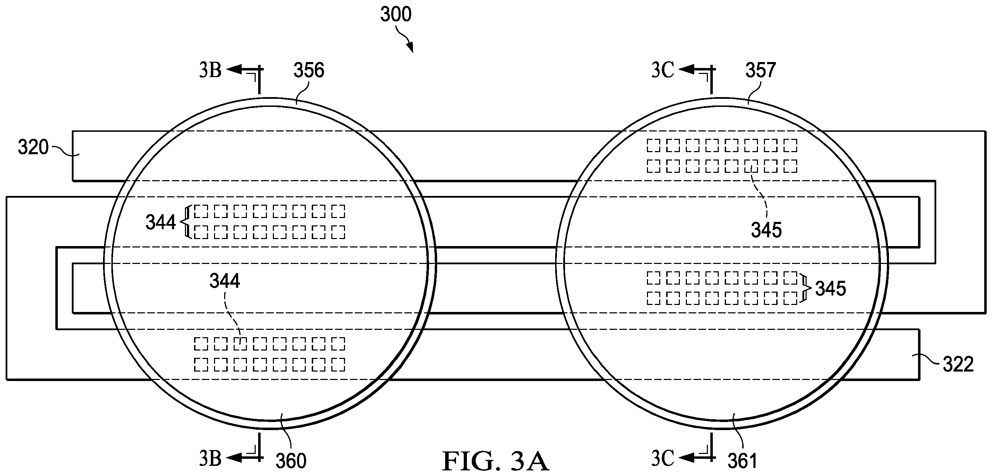

In addition, although some of the embodiments illustrated herein are shown in two dimensional views with various regions having depth and width, it should be clearly understood that these regions are illustrations of only a portion of a device that is actually a three dimensional structure. Accordingly, these regions will have three dimensions, including length, width, and depth, when fabricated on an actual device. Moreover, while the present invention is illustrated by embodiments directed to active devices, it is not intended that these illustrations be a limitation on the scope or applicability of the present invention. It is not intended that the active devices of the present invention be limited to the physical structures illustrated. These structures are included to demonstrate the utility and application of the present invention to presently preferred embodiments. In the following description, the device described in relation to Figs.3A-3C forms part of the invention as claimed. Other described devices do not form part of the invention as claimed.

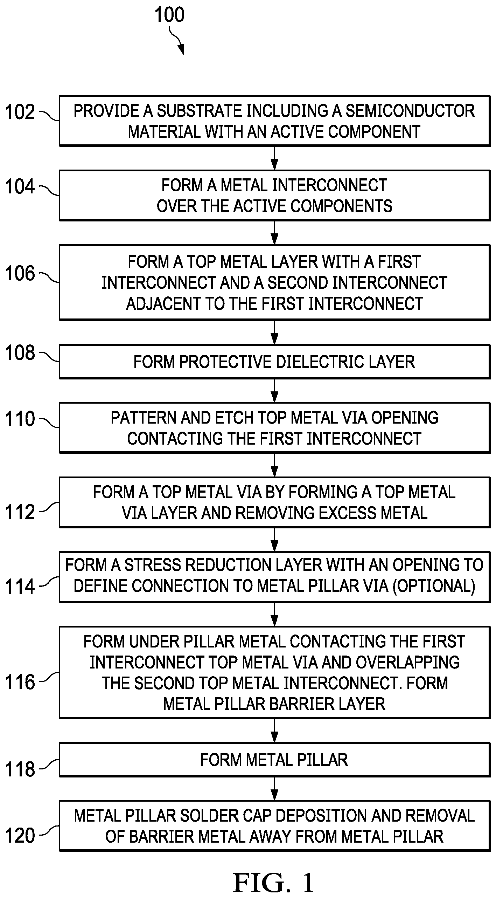

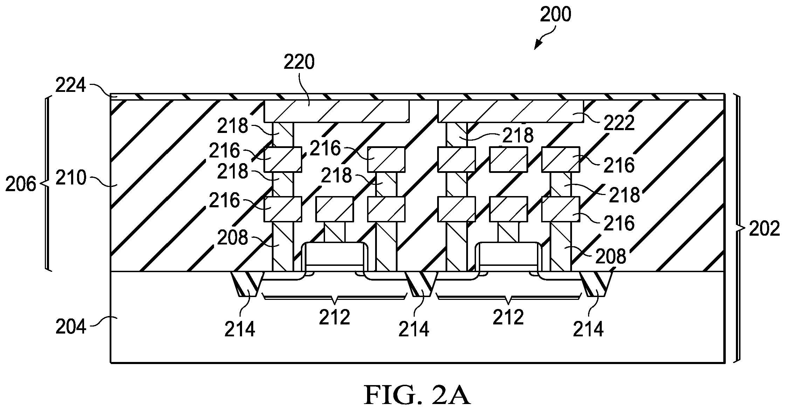

FIG. 1 is a flowchart of an example method **100** of forming a semiconductor device **200,** according to a comparative example not forming part of the invention as claimed. The semiconductor device **200** and elements of the semiconductor device **200** are shown in FIG. 2A through FIG. 2H. The method **100** begins with step **102,** providing a device substrate **202** including a semiconductor material **204.** The device substrate **202** may be part of a semiconductor wafer containing additional unfinished semiconductor devices. The semiconductor device **200** may be implemented as an integrated circuit or a discrete component, by way of example. Other implementations of the semiconductor device **200** are within the scope of this example. The semiconductor device **200** includes a semiconductor component **212,** such as a transistor.

In step 104, an interconnect region 206 is formed over the semiconductor component 212. The metal interconnect system includes dielectric layers, and may include interconnects 216, contacts 208 and vias 218, for example.

In step 106, a top metal layer is formed to complete the interconnect system. The top metal layer contains a first top metal interconnect lead 222 and a second top metal interconnect lead 220, which is adjacent to the first top metal interconnect lead 222. The top metal layer may contain more interconnect leads than the first top metal interconnect lead 222 and second top metal interconnect lead 220.

In step 108, a protective dielectric layer 226 is formed over the top metal layer. The protective dielectric layer 226 may include two or more sublayers of dielectric material, such as silicon dioxide, silicon nitride, silicon oxynitride, silicon carbide, silicon carbonitride, or aluminum oxide. The protective dielectric layer 226 formed in step 108 provides mechanical support for the top metal layer during a subsequent operation. The protective dielectric layer 226 may also contain a single dielectric material including one of silicon oxynitride or silicon nitride.

In step **110,** top metal via features **238** are formed in the protective dielectric layer **226.** The formation of the top metal via features **238** consists of a photolithography patterning step followed by a plasma etch step to form the top metal via features **238** through the protective dielectric layer **226** to the underlying first top metal interconnect. The etching of the top level via features **238** may be facilitated by the inclusion of a protective dielectric etch stop layer **224** of the protective dielectric layer **226,** formed on the top metal layer. The protective dielectric etch stop layer **224,** if used, is removed from the area for the top level via features **238.**

In step **112,** top metal vias **244** are formed. The formation of the top metal vias **244** consists of first forming a top metal via layer of copper or tungsten over the protective dielectric layer **226** and in the top level via features **238.** After the formation of the top metal via layer, a chemical mechanical polish (CMP) process is used to remove excess metal over the protective dielectric and leave metal remaining in the top metal via features **238.**

After the formation of the top metal vias **244** , step **114** includes forming a stress relief layer **248** with a metal pillar via **252.** The stress relief layer **248** is deposited on the wafer on top of the protective dielectric layer **226** and the top metal vias **244.** The stress relief layer **248** is an optional feature and may include a polyimide, polybenzoxazole (PBO) or benzocyclobutene (BCB). After the deposition of the stress reduction layer, either a pattern and etch step or photosensitive developer step can be used to in conjunction with a photosensitive stress reduction layer to remove stress reduction material from areas necessary to form the metal pillar via **252.** The metal pillar via **252** exposes the top metal via contacting the first top metal interconnect lead **222.** The metal pillar via **252** overlaps the second metal interconnect. The second top metal interconnect lead **220** is not electrically connected to the metal pillar via **252.**

Referring to step **116,** in a first example where a stress reduction layer is not used, a metal pillar barrier layer **258** is formed. The metal pillar barrier layer **258** includes a material selected from a group consisting of titanium, tantalum, tungsten, titanium nitride, and tantalum nitride or titanium tungsten. The barrier metal layer being between 20 nanometers and 500 nanometers by way of example. After the barrier layer is deposited, a metal seed layer of copper is deposited on the wafer. The metal seed layer being between 20 nanometers and 500 nanometers thick by way of example. In a second example, after the formation of the stress reduction layer in step **114,** a resist is deposited and patterned on the wafer. After the resist is patterned on the wafer, the metal pillar barrier layer **258** and metal seed layer are deposited.

In a third example, after the formation of the stress reduction layer in step **114,** an optional under pillar metal layer may be formed in the metal pillar via, contacting the first top metal interconnect lead **222** through the top metal via and overlapping the second top metal interconnect lead **220.** The second top metal interconnect lead **220** is not electrically connected to the under pillar metal layer. The under pillar metal layer may be formed from a material selected from a group consisting of copper and aluminum. After the formation of the under pillar metal layer, a metal pillar barrier layer **258** is and metal seed layer are deposited. The under pillar metal layer and the under pillar barrier layer are removed in regions outside of the metal pillar via by a CMP or plasma etch process.

In the metal pillar formation step **118,** a photoresist is deposited on the semiconductor wafer and is exposed in regions where pillars are to be formed. After exposure of the resist, the wafer is placed in an electroplating bath, which forms a metal pillar on the metal pillar barrier layer **258** by an electroplating process. After the electroplating process, the photoresist is removed, leaving the metal pillar. If an underlying barrier and metal seed layers remains after the electroplating process, a wet etch is used to remove the barrier and metal seed layers in areas which were not electroplated with metal pillars. The metal pillar overlaps to first top metal interconnect lead **222** and the second top metal interconnect lead **220.** The metal pillar **260** is electrically connected to the first top metal interconnect lead **222** through the top metal via. The metal pillar **260** is not electrically connected to the second top metal interconnect lead **220.** In at least one comparative example, a metal pillar cap **120** is added on top of the metal pillar **260.** The metal pillar cap **120** includes a material selected from a group consisting of tin, zinc, antimony, copper, silver, bismuth, lead, and indium.

FIG. 2A through FIG. 2H are cross sections of the process steps in the formation of semiconductor device **200.** Referring to FIG. 2A, the semiconductor device **200** may be implemented as an integrated circuit or a discrete component, and the device substrate **202** may be part of a semiconductor wafer containing additional semiconductor devices, not shown in FIG. 2A. The device substrate **202** includes a semiconductor material **204.** The semiconductor material **204** may include crystalline silicon, or may include another semiconductor material **204,** such as silicon germanium, silicon carbide, gallium nitride, or gallium arsenide, by way of example. The semiconductor device **200** includes an interconnect region **206** on the semiconductor material **204.** The semiconductor device **200** further includes a semiconductor component **212;** in this example, the semiconductor component **212** is implemented as a metal oxide semiconductor (MOS) transistor extending partway into the semiconductor material **204** and the interconnect region **206.** Other implementations of the semiconductor component **212,** such as a bipolar junction transistor, a diode, or a junction field effect transistor (JFET), are within the scope of this example. The semiconductor device **200** may include passive elements, such as trench isolation **214** located at the boundary between the semiconductor material **204** and the interconnect region **206.**

The interconnect region **206** includes a dielectric material stack **210** with dielectric sublayers of silicon dioxide, phosphosilicate glass (PSG), fluorinated silicate glass (FSG), borophosphosilicate glass (BPSG), organosilicate glass (OSG), low-k dielectric material, silicon nitride, silicon oxynitride, silicon carbide, silicon carbide nitride, or other dielectric material. The interconnect region **206** includes electrically conductive elements, such as the contacts **208** which make the electrical connections to the semiconductor component **212** and the semiconductor material **204,** interconnects **216** in one or more interconnect levels, wherein the interconnects **216** in a first of the interconnect levels make electrical connections to the contacts **208,** and vias **218** which electrically connect the interconnects **216** in successive interconnect levels and is completed with a first top metal interconnect lead **222** and a second top metal interconnect lead **220** which is adjacent to the first top metal interconnect lead **222.** While three levels of interconnect are shown, the number of interconnect levels varies depending on the application. Typically, between 2 and 9 levels of metal are used. A protective dielectric etch stop layer **224** is deposited over the interconnect region **206** in at least one comparative example. The protective dielectric etch stop layer **224** may include silicon nitride, for example, formed by a plasma enhanced chemical vapor deposition (PECVD) process using dichlorosilane and ammonia, or bis(tertiary-butyl-amino) silane, SiH₂[NH(C₄H₉)]₂ (BTBAS). The protective dielectric etch stop layer **224** may have a thickness of 100 nanometers to 300 nanometers, by way of example.

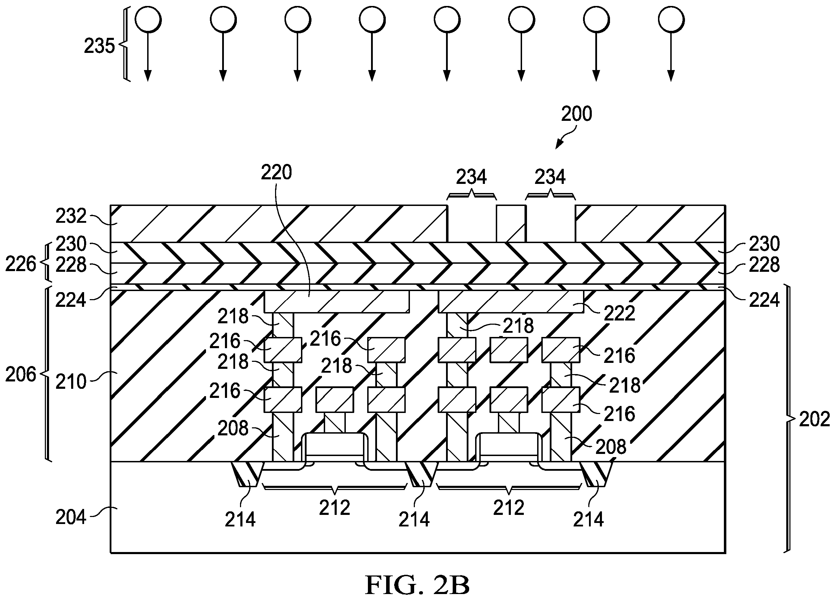

Referring to FIG. 2B, a protective dielectric layer **226** is formed over the protective dielectric etch stop layer **224.** The protective dielectric layer **226** may include a first sublayer **228** formed on the protective dielectric etch stop layer **224** and a second sublayer **230** formed on the first sublayer **228.** The first sublayer **228** may include silicon dioxide, formed by a PECVD process using tetraethyl orthosilicate (TEOS), Si(OC₂H₅)₄, and oxygen. The first sublayer **228** may have a thickness of 0.4 micron to 3 microns, by way of example. The second sublayer **230** may include silicon oxynitride, formed by a PECVD process using TEOS and BTBAS. The second sublayer **230** may have a thickness of 0.4 microns to 2 microns, by way of example. A protective dielectric layer **226** with multiple layers such as SiN/TEOS/SiON/TEOS may also be used. Other sublayer implementations for the protective dielectric layer **226,** such as additional sublayers or other dielectric materials such as silicon carbide or aluminum oxide, are within the scope of this example. Alternatively, the protective dielectric layer **226** may be implemented with a single homogeneous layer of dielectric material. An etch mask **232** is formed over the protective dielectric layer **226** over the first top metal interconnect lead **222** in areas for top metal via resist openings **234.** In at least one comparative example, the top metal via resist openings **234** can have an independent width and length. The etch mask **232** may include photoresist and may be formed by a photolithographic process. Removing the protective dielectric layer **226** in the top metal via resist openings **234** is done with a plasma etch process **235.**

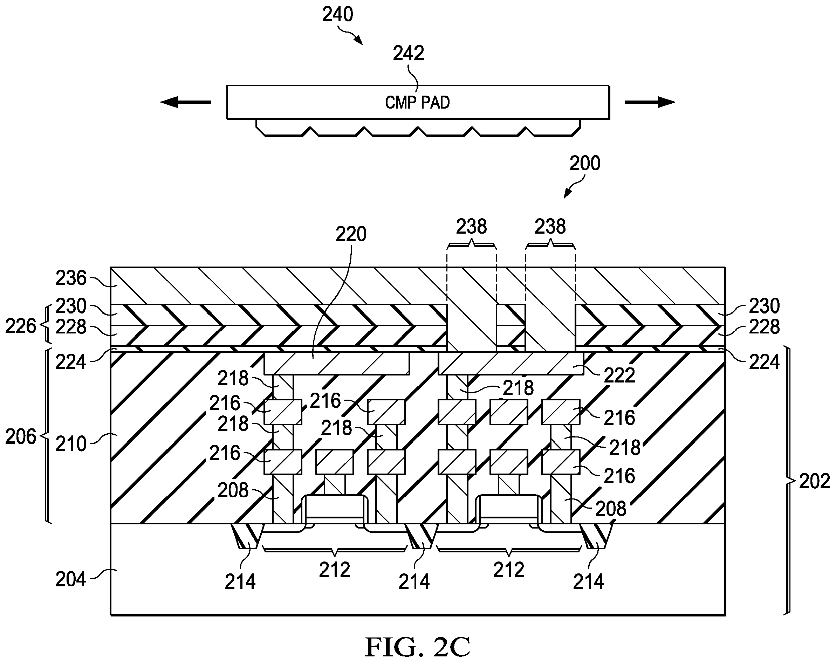

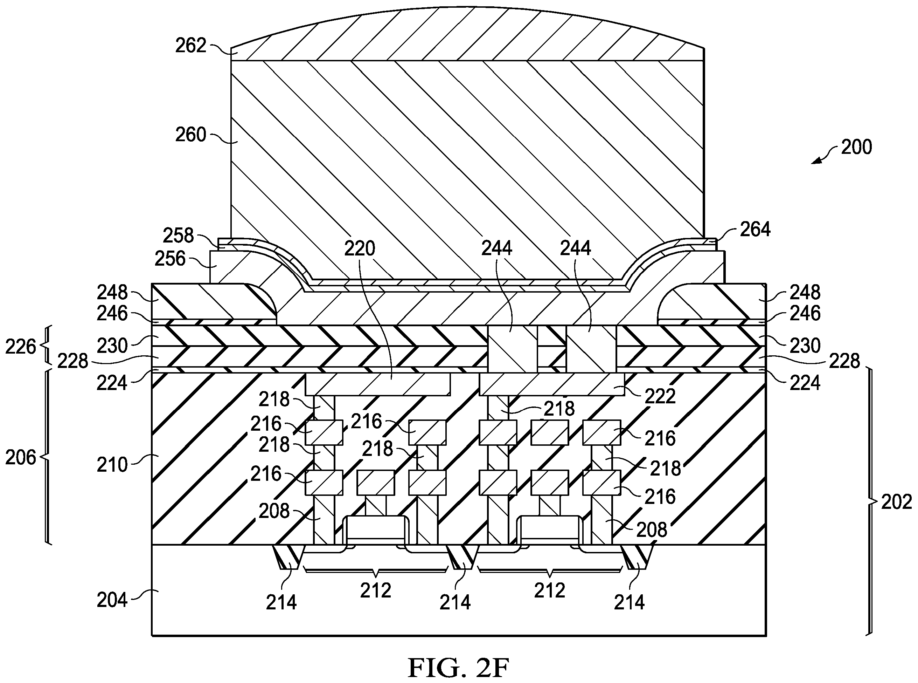

Referring to FIG. 2C, the protective dielectric layer **226** has top metal via features **238** formed by removal of the protective dielectric layer **226** in the top metal via resist openings **234** to expose the first top metal interconnect lead **222,** of FIG. 2B. A top metal via layer **236** is formed over the protective dielectric layer **226,** extends into the top metal via features **238,** and makes contact with the first top metal interconnect lead **222.** The top metal via layer **236** is electrically conductive and may consist of copper or tungsten, by way of example. The top metal via layer **236** may include an underlying barrier layer of Tantalum, Tantalum nitride, Titanium, Titanium nitride or a combination thereof by way of example. A CMP operation **240** using a CMP pad **242,** removes the top metal via layer **236** from over the protective dielectric layer **226,** leaving the top metal via layer **236** in the top metal via features **238** allowing connection of a metal pillar **260,** shown in FIG. 2F, to the first top metal interconnect lead **222** while the protective dielectric layer **226** separates the second top metal interconnect lead **220** from the metal pillar **260.**

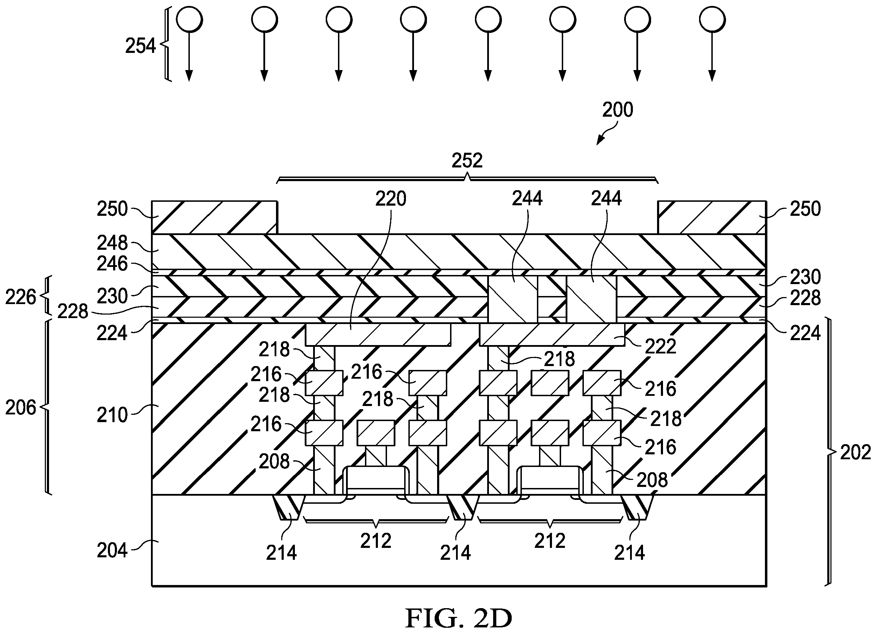

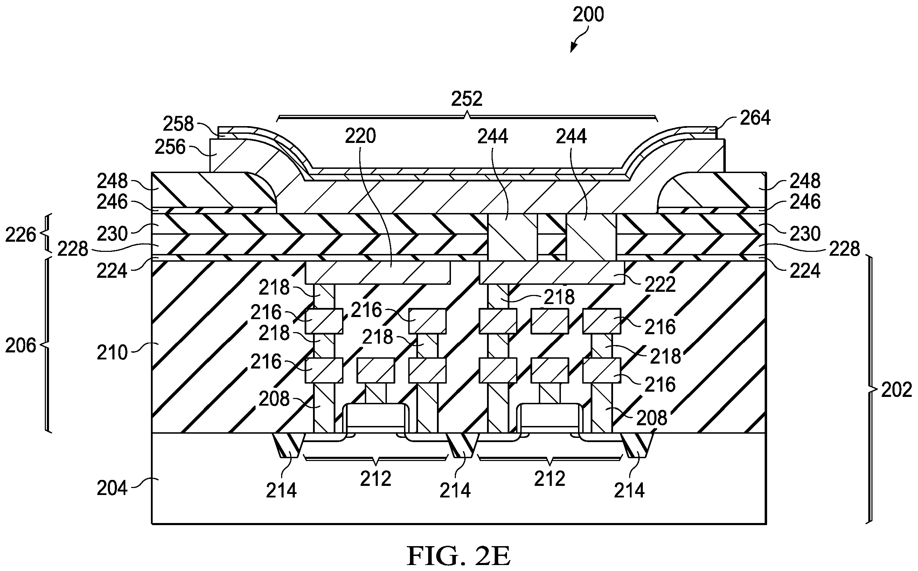

Referring to FIG. 2D, after the formation of the top metal vias **244** a stress relief etch stop layer **246** and a stress relief layer **248** are formed on top of the protective dielectric layer **226** in at least one comparative example. The stress relief etch stop layer **246** can consist of one of silicon nitride or silicon oxynitride. The stress relief layer **248** can consist of a polyimide, n-polybenzoxazole or material with like physical characteristics. After the deposition of the stress relief etch stop layer **246** and the stress relief layer **248,** a photoresist layer **250** is deposited on top of the stress relief layer **248** and patterned. The photoresist layer **250** has an opening for a metal pillar via **252,** shown in FIG. 2E, formed through the protective dielectric layer **226.** The opening for the metal pillar via **252** exposes the areas that connect subsequent layers to the top metal vias **244.** After the definition of the photolithographic pattern (not specifically shown), a plasma etch process **254** is used to etch the stress relief layer **248** and stress relief etch stop layer **246** to form the metal pillar via **252.** After the plasma etch process **254,** the resist is removed.

Referring to FIG. 2E, an under metal pillar metal layer **256** and an under metal pillar barrier layer **258** are deposited on the stress relief layer **248.** The under metal pillar metal layer **256** and the under metal pillar barrier layer **258** extend into the metal pillar via **252** and contact the top metal vias **244.** A photolithographic process and an etch process (not shown) define a region of under metal pillar metal layer **256** and under metal pillar barrier layer **258** over top metal vias **244** which are connected to the first top metal interconnect lead **222,** while overlapping but not making a direct electrical connection with the second top metal interconnect lead **220.** The under metal pillar barrier layer **258** is a barrier sublayer under the metal pillar **260.** The under metal pillar barrier layer **258** including a material selected from a group consisting of titanium, tantalum, tungsten, titanium nitride, and tantalum nitride. After the formation of the under metal pillar barrier layer **258** a metal pillar seed layer **264** of copper is deposited.

Referring to FIG. 2F, a cross section of the semiconductor device **200** including the metal pillar **260** and the metal pillar cap **262** are shown. A resist layer (not specifically shown) is coated on the semiconductor substrate or wafer. After patterning and exposure of the resist, openings are formed in the resist coincident with the under metal pillar barrier layer **258** and metal pillar seed layer **264.** An electroplating bath is used to form the metal pillar **260** which plated on top of the barrier. The metal pillar **260** can be one of copper or nickel by way of example. After the electroplating process, the remaining resist is removed leaving the metal pillar **260,** and a wet etch is used to remove the remaining barrier and metal seed layer. A metal pillar **260** can range in height from 30 microns to 120 microns by way of example.

After the metal pillar **260** is formed, in at least one comparative example, a metal pillar cap **262** is deposited on the top metal pillar. The metal pillar cap **262** may include solder, and may include a diffusion barrier with nickel between the metal pillar **260** and the solder. The metal pillar cap **262** can be formed using a stencil or electroplating by way of example.

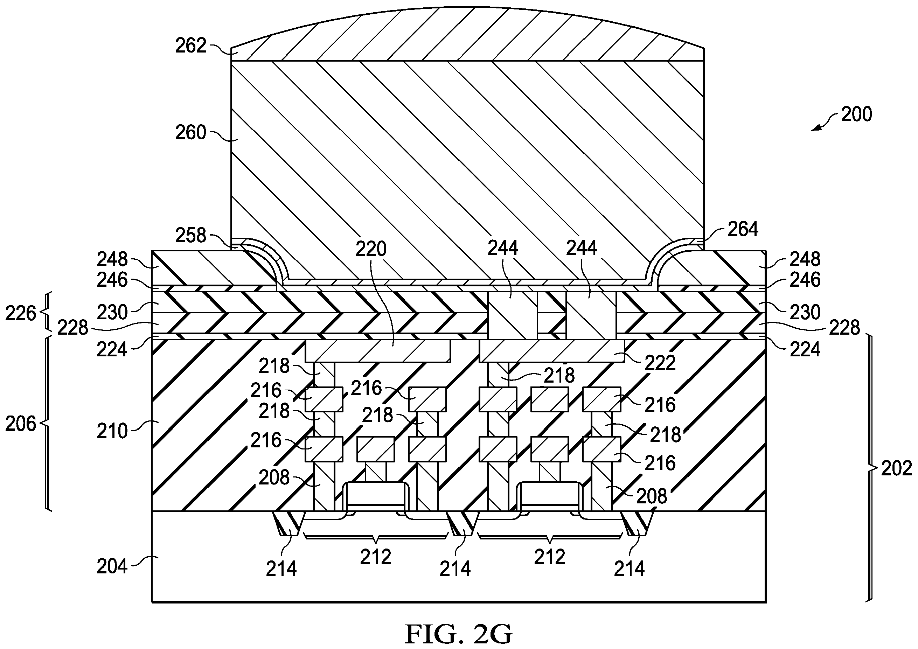

Referring to FIG. 2G, a cross section is shown of a semiconductor device **200** which contains a stress relief layer **248,** but does not contain the under metal pillar metal layer **256** present in FIG. 2F.

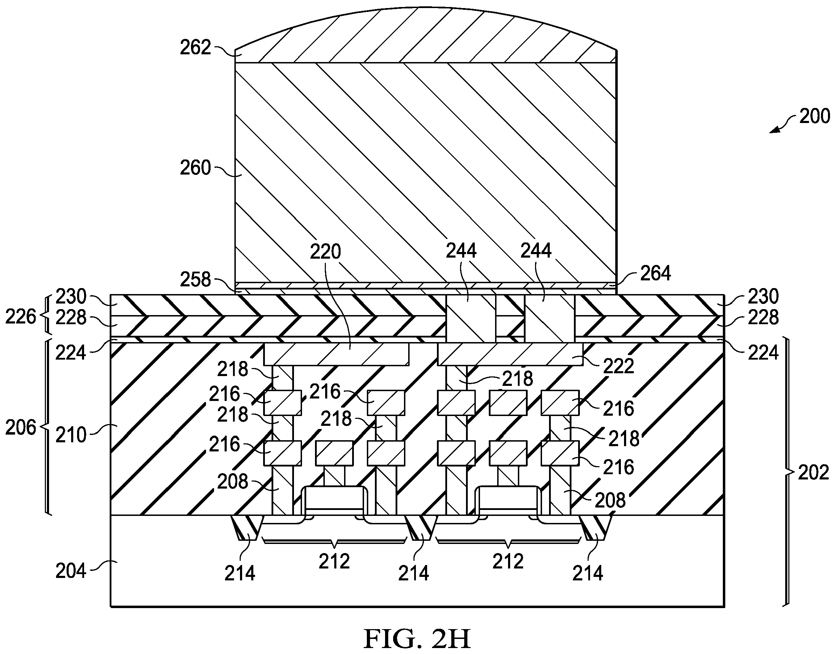

Referring to FIG. 2H, a cross section is shown of a semiconductor device **200** which does not contain the stress relief layer **248** or the under metal pillar metal layer **256** shown in FIG. 2F.

Referring to FIG. 3A, a top down view of an example semiconductor device **300** according to the invention is shown. FIG. 3A shows a via level including connecting first top metal vias **344** through the protective dielectric layer and second top metal vias **345** through the protective dielectric layer, the first top metal vias **344** contacting the first top metal interconnect lead **322** and the second top metal vias **345** contacting the second top metal interconnect lead **320.** A first metal pillar **360** is shown with a first under pillar metal layer **356** which electrically connects a first top metal interconnect **322** through a plurality of first top metal vias **344.** While the first metal pillar **360** and first under pillar metal layer **356** overlap a second top metal interconnect **320** which is between two tines of the first top metal interconnect **322** of the example shown in FIG. 3A, the second top metal interconnect **320** is free of a connection to the first metal pillar **360** and first under pillar metal layer **356.** Likewise, a second metal pillar **361** and second under pillar metal layer **357** are connected to the second top metal interconnect **320** through a plurality of second top metal vias **345.** The first top metal interconnect **322** in FIG. 3A is overlapped by the second metal pillar **361,** and is shown between two tines of the second top metal interconnect **320.** The first top metal interconnect **322** is free of any connection to the second metal pillar **361** and second under pillar metal layer **357.**

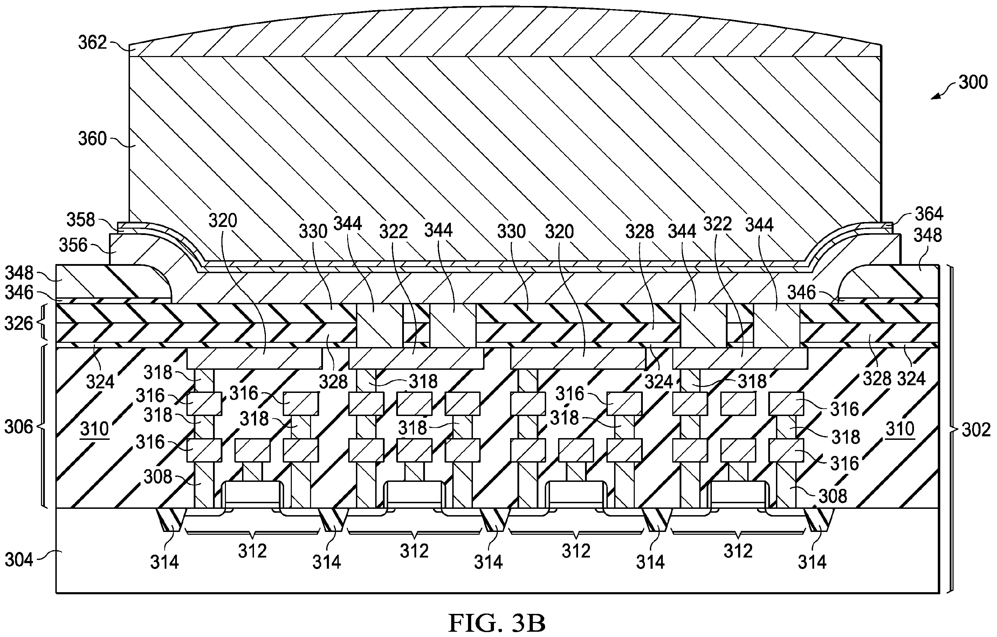

Referring to FIG. 3B, a cross section through the first metal pillar **360** and the first under pillar metal layer **356** is shown. The first metal pillar **360** and the first under pillar metal layer **356** connect to the first top metal interconnect **322** through first top metal vias **344.** While the first metal pillar **360** and first under pillar metal layer **356** overlap the second top metal interconnect **320** which is interdigitated with the tines of the first top metal interconnect **322** of the example shown in FIG. 3B, the second top metal interconnect **320** is free of a connection to the first metal pillar **360** and first under pillar metal layer **356.** Additional features shown in FIG. 3B include a device substrate **302,** a semiconductor material **304,** an interconnect region **306,** contacts **308,** a dielectric material stack **310,** a semiconductor component **312,** trench isolation, **314,** interconnects **316,** vias **318,** a protective dielectric etch stop layer **324,** a protective dielectric layer **326,** a first sublayer **328,** a second sublayer **330,** a stress relief layer **348,** under metal pillar barrier layer **358,** a metal pillar seed layer **364** and a metal pillar cap **362,** which are similar to corresponding features shown in FIG. 2A through FIG. 2H.

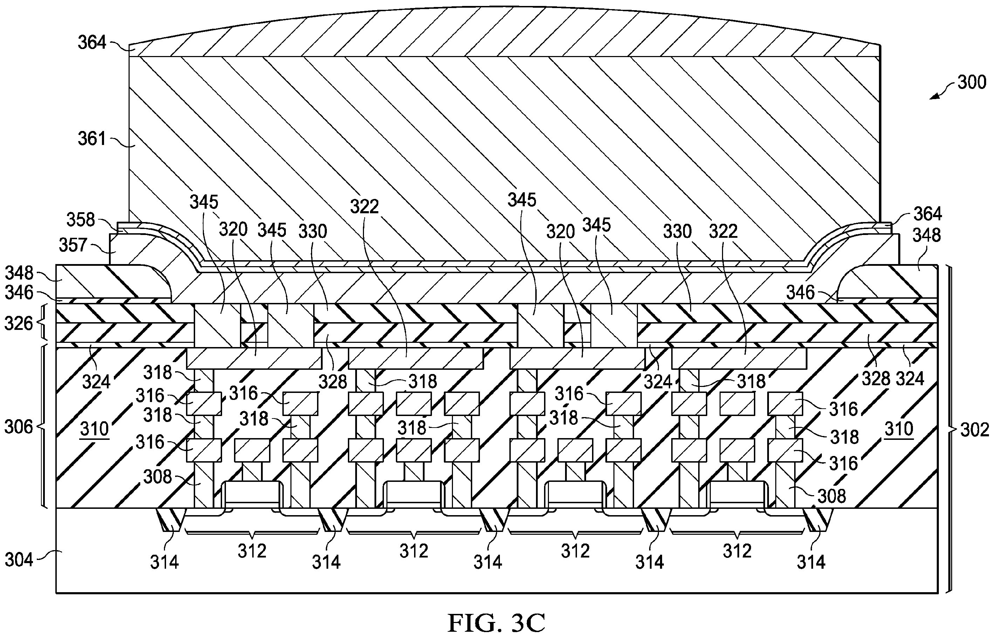

Referring to FIG. 3C, a cross section through the second metal pillar **361** and the second under pillar metal layer **357** is shown. The second metal pillar **361** and the second under pillar metal layer **357** connect to the second top metal interconnect **320** through second top metal vias **345.** While the second metal pillar **361** and second under pillar metal layer **357** overlap the first top metal interconnect **322** which is interdigitated with the tines of the second top metal interconnect **320** of the example shown in FIG. 3C, the first top metal interconnect **322** is free of a connection to the second metal pillar **361** and second under pillar metal layer **357.** Additional features shown in FIG. 3C include the device substrate **302,** semiconductor material **304,** interconnect region **306,** contacts 308, dielectric material stack **310,** semiconductor component **312,** trench isolation **314,** interconnects **316,** vias **318,** protective dielectric etch stop layer **324,** protective dielectric layer **326,** first sublayer **328,** second sublayer **330,** stress relief layer **348,** under metal pillar barrier layer **358,** metal pillar seed layer **364** and metal pillar cap **362.**

In this disclosure and the claims that follow, one or more layers or structures may be described as including substances such as aluminum, tungsten, copper, silicon nitride, etc. These descriptions are to be understood in context and as they are used in the semiconductor manufacturing industry. For example, in the semiconductor industry, when a metallization layer is described as copper, it is understood that the metal of the layer includes copper as a principal component, but the copper may be, and typically is, alloyed, doped, or otherwise impure. As another example, silicon nitride may be a silicon-rich silicon nitride or an oxygen-rich silicon nitride. Silicon nitride may contain some oxygen, but not so much that the materials dielectric constant is substantially different from that of high purity stoichiometric silicon nitride.

Additionally, unless stated otherwise and/or specified to the contrary, any one or more of the layers set forth herein can be formed in any number of suitable ways, such as with spin-on techniques, sputtering techniques (e.g., Magnetron and/or ion beam sputtering), (thermal) growth techniques and/or deposition techniques such as chemical vapor deposition (CVD), physical vapor deposition (PVD), PECVD, or atomic layer deposition (ALD), for example.

It is noted that terms such as top, over, above, underlying, and below may be used in this disclosure. These terms should not be construed as limiting the position or orientation of a structure or element, but should be used to provide spatial relationship between structures or elements.

While various embodiments of the present disclosure have been described above, it should be understood that they have been presented by way of example only and not limitation. Numerous changes to the disclosed embodiments can be made in accordance with the disclosure herein without departing from the scope defined by the appended claims. Thus, the breadth and scope of the present invention should not be limited by any of the above described embodiments. Rather, the scope of the disclosure should be defined in accordance with the following claims.

## Claims

1. A semiconductor device (300), comprising:
a substrate (302), the substrate (302) including a semiconductor material (304);
a semiconductor component (312) extending into the semiconductor material (304);
an interconnect region (306) over the semiconductor component (312);
a top metal layer in the interconnect region (306);
a protective dielectric layer (326) on the top metal layer;
a first top metal interconnect lead (322) in the top metal layer;
a second top metal interconnect lead (320) in the top metal layer;
top metal vias (344) through the protective dielectric layer (326), the top metal vias (344) contacting the first top metal interconnect lead (322); and
a metal pillar (360) electrically connected to the top metal vias (344); wherein:
the metal pillar (360) extends over a portion of the second top metal interconnect lead (320); and
the protective dielectric layer (326) separates the metal pillar (360) from the second top metal interconnect lead (320), the semiconductor device is free of a direct electrical connection through the protective dielectric layer from the metal pillar to the second top metal interconnect lead, and the protective dielectric layer (326) provides mechanical support for the top metal layer;
the semiconductor device (300) further comprising:
a via level including the top metal vias (344) through the protective dielectric layer (326) and second top metal vias (345) through the protective dielectric layer ( 326), the top metal vias (344) contacting the first top metal interconnect lead (322) and the second top metal vias (345) contacting the second top metal interconnect lead (320); and
the metal pillar (360) on the top metal vias (344) and a second metal pillar (361) on the second top metal vias (345); wherein:
the metal pillar (360) extends over a portion of the second top metal interconnect lead (320) and the second metal pillar (361) extends over a portion of the first top metal interconnect lead (322);
the protective dielectric layer (326) separates the metal pillar (360) from the second top metal interconnect lead (320) and separates the second metal pillar (361) from the first top metal interconnect lead (322); and **characterized in that**
the via level includes no vias between the metal pillar (360) and the second top metal interconnect lead (320) and no vias between the second metal pillar (361) and the first top metal interconnect lead (322).

2. The semiconductor device of claim 1 wherein the metal pillar (360)
a) includes a barrier sublayer (358) under the metal pillar (360), the barrier sublayer (358) including a material selected from a group consisting of titanium, tantalum, tungsten, titanium nitride, and tantalum nitride; or
b) includes a material selected from a group consisting of copper and nickel; or c) contains a cap (362) over the metal pillar (360); the cap (362) including a material selected from a group consisting of tin, zinc, antimony, copper, silver, bismuth, lead, and indium.

3. The semiconductor device of claim 1 wherein a metal layer electrically connects the top metal vias (344) to the metal pillar (360), the metal layer including a material selected from a group consisting of copper and aluminum.

4. The semiconductor device of claim 1, wherein the protective dielectric layer (326) includes a) a first sublayer (328) over the top metal layer, and includes a second sublayer (330) on the first sublayer (328), wherein the first sublayer (328) includes a material selected from a group consisting of silicon dioxide and silicon oxynitride and the second sublayer (230) includes a material selected from a group consisting of silicon oxynitride and silicon nitride; or b) a dielectric material selected from a group consisting of silicon oxynitride and silicon nitride.

5. The semiconductor device of claim 1, wherein the protective dielectric layer (326) includes an etch stop sublayer (324) over the top metal layer.

6. A method (100) of forming a semiconductor device (300), comprising:
forming (102) a semiconductor component (312) extending into a semiconductor material (304) of a device substrate (302);
forming (104) an interconnect region (306) on the semiconductor component (312), the interconnect region (306) including a top metal layer;
forming (106) a first top metal interconnect lead (322) in the top metal layer and a second top metal interconnect lead (320) in the top metal layer adjacent to the first top metal interconnect lead (322);
forming (108) a protective dielectric layer (326) on the top metal layer;
removing (110) the protective dielectric layer (326) in a top via openings in the protective dielectric layer (326) to expose a portion of the first top metal interconnect lead (322);
forming (112) top metal vias (344) in the top via openings contacting the first top metal interconnect lead (322); and
forming (118) a metal pillar (360) on the top metal vias (344); wherein:
the metal pillar (360) extends over a portion of the second top metal interconnect lead (320); and
the protective dielectric layer (326) separates the metal pillar (360) from the second top metal interconnect lead (320), the semiconductor device is free of a direct electrical connection through the protective dielectric layer from the metal pillar to the second top metal interconnect lead, and the protective dielectric layer (326) provides mechanical support for the top metal layer;
the method further comprising:
forming (112) second top metal vias (345) in the top via openings contacting the second top metal interconnect lead (320), wherein the top metal vias (344) and the second top metal vias (345) are included in a via level, the via level including the top metal vias (344) through the protective dielectric layer (326) and the second top metal vias (345) through the protective dielectric layer (326); and
forming (118) a second metal pillar (361) on the second top metal vias (345); wherein:
the metal pillar (360) extends over a portion of the second top metal interconnect lead (320) and the second metal pillar (361) extends over a portion of the first top metal interconnect lead (322);
the protective dielectric layer (326) separates the metal pillar (360) from the second top metal interconnect lead (320) and separates the second metal pillar (361) from the first top metal interconnect lead (322); and **characterized in that**
the via level includes no vias between the metal pillar (360) and the second top metal interconnect lead (320) and no vias between the second metal pillar (361) and the first top metal interconnect lead (322).

7. The method of claim 6, wherein forming (118) a metal pillar (360) includes a) forming a barrier sublayer (358) on the metal pillar (360), the barrier sublayer (358) including a material selected from a group consisting of titanium, tantalum, tungsten, titanium nitride, and tantalum nitride; or b) a material selected from a group consisting of copper and nickel.

8. The method of claim 6, wherein forming (118) a metal pillar cap (362) over the metal pillar (360) includes a material selected from a group consisting of tin, zinc, antimony, copper, silver, bismuth, lead, and indium.

9. The method of claim 6, wherein forming (108) the protective dielectric layer (326) includes a) forming a first sublayer (328) over the top metal layer, and includes forming a second sublayer (330) on the first sublayer (328), wherein the first sublayer (328) includes a material selected from a group consisting of silicon dioxide and silicon oxynitride and the second sublayer (330) includes a material selected from a group consisting of silicon oxynitride and silicon nitride; or b) forming a layer of a dielectric material selected from a group consisting of silicon oxynitride and silicon nitride; or c) forming a stress relief layer (348) over the top metal layer and removing the stress relief layer (348) in areas which exposes top metal vias (344).

10. The method of claim 6, further comprising forming (114) a stress relief layer (348) on top of the protective dielectric layer (326), the stress relief layer (348) including a material selected from polyimide or n-polybenzoxazole.

11. The method of claim 6, wherein forming (118) the metal pillar (360) includes forming an under metal pillar metal layer (356) which includes a material selected from a group consisting of copper and aluminum.

## Patentansprüche

1. Halbleitervorrichtung (300), umfassend:
ein Substrat (302), wobei das Substrat (302) ein Halbleitermaterial (304) beinhaltet;
eine Halbleiterkomponente (312), die sich in das Halbleitermaterial (304) erstreckt;
ein Zwischenverbindungsgebiet (306) über der Halbleiterkomponente (312);
eine obere Metallschicht in dem Zwischenverbindungsgebiet (306);
eine dielektrische Schutzschicht (326) auf der oberen Metallschicht;
einen ersten oberen metallischen Zwischenverbindungsstift (322) in der oberen Metallschicht;
einen zweiten oberen metallischen Zwischenverbindungsstift (320) in der oberen Metallschicht;
obere metallische Durchkontaktierungen (344) durch die dielektrische Schutzschicht (326), wobei die oberen metallischen Durchkontaktierungen (344) in einem Kontakt mit dem ersten oberen metallischen Zwischenverbindungsstift (322) stehen; und
eine Metallsäule (360), die mit den oberen metallischen Durchkontaktierungen (344) elektrisch verbunden ist; wobei:
sich die Metallsäule (360) über einem Abschnitt des zweiten oberen metallischen Zwischenverbindungsstifts (320) erstreckt; und
die dielektrische Schutzschicht (326) die Metallsäule (360) von dem zweiten oberen metallischen Zwischenverbindungsstift (320) trennt, wobei die Halbleitervorrichtung frei ist von einer direkten elektrischen Verbindung durch die dielektrische Schutzschicht von der Metallsäule zu dem zweiten oberen metallischen Zwischenverbindungsstift und wobei die dielektrische Schutzschicht (326) eine mechanische Unterstützung für die obere Metallschicht bereitstellt;
wobei die Halbleitervorrichtung (300), ferner umfasst:
eine Durchkontaktierungsebene, welche die oberen metallischen Durchkontaktierungen (344) durch die dielektrische Schutzschicht (326) und zweite obere metallische Durchkontaktierungen (345) durch die dielektrische Schutzschicht (326) beinhaltet, wobei die oberen metallischen Durchkontaktierungen (344) mit dem ersten oberen metallischen Zwischenverbindungsstift (322) in einem Kontakt stehen und wobei die zweiten oberen metallischen Durchkontaktierungen (345) mit dem zweiten oberen metallischen Zwischenverbindungsstift (320) in einem Kontakt stehen; und
die Metallsäule (360) auf den oberen metallischen Durchkontaktierungen (344) und eine zweite Metallsäule (361) auf den zweiten oberen metallischen Durchkontaktierungen (345);
wobei:
sich die Metallsäule (360) über einem Abschnitt des zweiten oberen metallischen Zwischenverbindungsstifts (320) erstreckt und wobei sich die zweite Metallsäule (361) über einem Abschnitt des ersten oberen metallischen Zwischenverbindungsstifts (322) erstreckt;
wobei die dielektrische Schutzschicht (326) die Metallsäule (360) von dem zweiten oberen metallischen Zwischenverbindungsstift (320) trennt und die zweite Metallsäule (361) von dem ersten oberen metallischen Zwischenverbindungsstift (322) trennt; und **dadurch gekennzeichnet, dass**
die Durchkontaktierungsebene keine Durchkontaktierungen zwischen der Metallsäule (360) und dem zweiten oberen metallischen Zwischenverbindungsstift (320) und keine Durchkontaktierungen zwischen der zweiten Metallsäule (361) und dem ersten oberen metallischen Zwischenverbindungsstift (322) beinhaltet.

2. Halbleitervorrichtung nach Anspruch 1, wobei die Metallsäule (360) a) eine Barriereteilschicht (358) unter der Metallsäule (360) beinhaltet, wobei die Barriereteilschicht (358) ein Material beinhaltet, das aus einer Gruppe ausgewählt wird, die aus Titan, Tantal, Wolfram, Titannitrid und Tantalnitrid besteht; oder b) ein Material beinhaltet, das aus einer Gruppe ausgewählt wird, die aus Kupfer und Nickel besteht; oder c) einen Deckel (362) über der Metallsäule (360) enthält; wobei der Deckel (362) ein Material beinhaltet, das aus einer Gruppe ausgewählt wird, die aus Zinn, Zink, Antimon, Kupfer, Silber, Wismut, Blei und Indium besteht.

3. Halbleitervorrichtung nach Anspruch 1, wobei eine Metallschicht die oberen metallischen Durchkontaktierungen (344) mit der Metallsäule (360) elektrisch verbindet, wobei die Metallschicht ein Material beinhaltet, das aus einer Gruppe ausgewählt ist, die aus Kupfer und Aluminium besteht.

4. Halbleitervorrichtung nach Anspruch 1, wobei die dielektrische Schutzschicht (326) beinhaltet: a) eine erste Teilschicht (328) über der oberen Metallschicht und eine zweite Teilschicht (330) auf der ersten Teilschicht (328), wobei die erste Teilschicht (328) ein Material beinhaltet, das aus einer Gruppe ausgewählt wird, die aus Siliciumdioxid und Siliciumoxynitrid besteht, und wobei die zweite Teilschicht (230) ein Material beinhaltet, das aus einer Gruppe ausgewählt wird, die aus Siliciumoxynitrid und Siliciumnitrid besteht; oder b) ein dielektrisches Material, das aus einer Gruppe ausgewählt wird, die aus Siliciumoxynitrid und Siliciumnitrid besteht.

5. Halbleitervorrichtung nach Anspruch 1, wobei die dielektrische Schutzschicht (326) eine Ätzstoppteilschicht (324) über der oberen Metallschicht beinhaltet.

6. Verfahren (100) zum Bilden einer Halbleitervorrichtung (300), umfassend:
Bilden (102) einer Halbleiterkomponente (312), die sich in ein Halbleitermaterial (304) eines Vorrichtungssubstrats (302) erstreckt;
Bilden (104) eines Zwischenverbindungsgebiets (306) auf der Halbleiterkomponente (312), wobei das Zwischenverbindungsgebiet (306) eine obere Metallschicht beinhaltet;
Bilden (106) eines ersten oberen metallischen Zwischenverbindungsstifts (322) in der oberen Metallschicht und eines zweiten oberen metallischen Zwischenverbindungsstift (320) in der oberen Metallschicht benachbart zu dem ersten oberen metallischen Zwischenverbindungsstift (322);
Bilden (108) einer dielektrischen Schutzschicht (326) auf der oberen Metallschicht;
Entfernen (110) der dielektrischen Schutzschicht (326) in einer oberen Durchkontaktierungsöffnung in der dielektrischen Schutzschicht (326), um einen Abschnitt des ersten oberen metallischen Zwischenverbindungsstifts (322) freizulegen;
Bilden (112) von oberen metallischen Durchkontaktierungen (344) in den oberen Durchkontaktierungsöffnungen, die mit dem ersten oberen metallischen Zwischenverbindungsstift (322) in einem Kontakt stehen; und
Bilden (118) einer Metallsäule (360) auf den oberen metallischen Durchkontaktierungen (344); wobei:
sich die Metallsäule (360) über einem Abschnitt des zweiten oberen metallischen Zwischenverbindungsstifts (320) erstreckt; und
die dielektrische Schutzschicht (326) die Metallsäule (360) von dem zweiten oberen metallischen Zwischenverbindungsstift (320) trennt, wobei die Halbleitervorrichtung frei ist von einer direkten elektrischen Verbindung durch die dielektrische Schutzschicht von der Metallsäule zu dem zweiten oberen metallischen Zwischenverbindungsstift und wobei die dielektrische Schutzschicht (326) eine mechanische Unterstützung für die obere Metallschicht bereitstellt;
wobei das Verfahren ferner umfasst:
Bilden (112) von zweiten oberen metallischen Durchkontaktierungen (345) in den oberen Durchkontaktierungsöffnungen, die mit dem zweiten oberen metallischen Zwischenverbindungsstift 320) in einem Kontakt stehen, wobei die oberen metallischen Durchkontaktierungen (344) und die zweiten oberen metallischen Durchkontaktierungen (345) in einer Durchkontaktierungsebene enthalten sind, wobei die Durchkontaktierungsebene die oberen metallischen Durchkontaktierungen (344) durch die dielektrische Schutzschicht (326) und die zweiten oberen metallischen Durchkontaktierungen (345) durch die dielektrische Schutzschicht (326) beinhaltet; und
Bilden (118) einer zweiten Metallsäule (361) auf den zweiten oberen metallischen Durchkontaktierungen (345); wobei:
sich die Metallsäule (360) über einem Abschnitt des zweiten oberen metallischen Zwischenverbindungsstifts (320) erstreckt und wobei sich die zweite Metallsäule (361) über einem Abschnitt des ersten oberen metallischen Zwischenverbindungsstifts (322) erstreckt;
wobei die dielektrische Schutzschicht (326) die Metallsäule (360) von dem zweiten oberen metallischen Zwischenverbindungsstift (320) trennt und die zweite Metallsäule (361) von dem ersten oberen metallischen Zwischenverbindungsstift (322) trennt; und **dadurch gekennzeichnet, dass**
die Durchkontaktierungsebene keine Durchkontaktierungen zwischen der Metallsäule (360) und dem zweiten oberen metallischen Zwischenverbindungsstift (320) und keine Durchkontaktierungen zwischen der zweiten Metallsäule (361) und dem ersten oberen metallischen Zwischenverbindungsstift (322) beinhaltet.

7. Verfahren nach Anspruch 6, wobei das Bilden (118) einer Metallsäule (360) beinhaltet: a) Bilden einer Barriereteilschicht (358) auf der Metallsäule (360), wobei die Barriereteilschicht (358) ein Material beinhaltet, das aus einer Gruppe ausgewählt ist, die aus Titan, Tantal, Wolfram, Titannitrid und Tantalnitrid besteht; oder b) ein Material beinhaltet, das aus einer Gruppe ausgewählt ist, die aus Kupfer und Nickel besteht.

8. Verfahren nach Anspruch 6, wobei das Bilden (118) eines Metallsäulendeckels (362) über der Metallsäule (360) ein Material beinhaltet, das aus einer Gruppe ausgewählt ist, die aus Zinn, Zink, Antimon, Kupfer, Silber, Wismut, Blei und Indium besteht.

9. Verfahren nach Anspruch 6, wobei das Bilden (108) der dielektrischen Schutzschicht (326) beinhaltet: a) Bilden einer ersten Teilschicht (328) über der oberen Metallschicht und einer zweiten Teilschicht (330) auf der ersten Teilschicht (328), wobei die erste Teilschicht (328) ein Material beinhaltet, das aus einer Gruppe ausgewählt wird, die aus Siliciumdioxid und Siliciumoxynitrid besteht, und wobei die zweite Teilschicht (330) ein Material beinhaltet, das aus einer Gruppe ausgewählt wird, die aus Siliciumoxynitrid und Siliciumnitrid besteht; oder b) Bilden einer Schicht aus einem dielektrischen Material, das aus einer Gruppe ausgewählt wird, die aus Siliciumoxynitrid und Siliciumnitrid besteht; oder c) Bilden einer Spannungsentlastungsschicht (348) über der oberen Metallschicht und Entfernen der Spannungsentlastungsschicht (348) in Bereichen, in denen obere metallische Durchkontaktierungen (344) freiliegen.

10. Verfahren nach Anspruch 6, das ferner ein Bilden (114) einer Spannungsentlastungsschicht (348) oben auf der dielektrischen Schutzschicht (326) umfasst, wobei die Spannungsentlastungsschicht (348) ein Material beinhaltet, das aus Polyimid oder n-Polybenzoxazol ausgewählt wird.

11. Verfahren nach Anspruch 6, wobei das Bilden (118) der Metallsäule (360) ein Bilden einer Metallschicht (356) unter der Metallsäule beinhaltet, die ein Material beinhaltet, das aus einer Gruppe ausgewählt ist, die aus Kupfer und Aluminium besteht.

## Revendications

1. Dispositif à semi-conducteurs (300) comprenant :
un substrat (302), le substrat (302) comprenant un matériau semi-conducteur (304) ;
un composant semi-conducteur (312) s'étendant dans le matériau semi-conducteur (304) ;
une région d'interconnexion (306) sur le composant semi-conducteur (312) ;
une couche métallique supérieure dans la région d'interconnexion (306) ;
une couche diélectrique de protection (326) sur la couche métallique supérieure ;
un premier conducteur d'interconnexion métallique supérieur (322) dans la couche métallique supérieure ;
un deuxième conducteur d'interconnexion métallique supérieur (320) dans la couche métallique supérieure ;
des trous d'interconnexion métalliques supérieurs (344) traversent la couche diélectrique de protection (326), les trous d'interconnexion métalliques supérieurs (344) étant en contact avec le premier conducteur d'interconnexion métallique supérieur (322) ; et
un pilier métallique (360) connecté électriquement aux trous d'interconnexion métalliques supérieurs (344) ; où :
le pilier métallique (360) s'étend sur une partie du deuxième conducteur d'interconnexion métallique supérieur (320) ; et
la couche diélectrique de protection (326) sépare le pilier métallique (360) du deuxième conducteur d'interconnexion métallique supérieur (320), le dispositif à semi-conducteur est exempt de connexion électrique directe à travers la couche diélectrique de protection du pilier métallique au deuxième conducteur d'interconnexion métallique supérieur, et la couche diélectrique de protection (326) fournit un support mécanique à la couche métallique supérieure ;
dispositif à semi-conducteurs (300) comprenant en outre :
un niveau de trous d'interconnexion comprenant les trous d'interconnexion métalliques supérieurs (344) à travers la couche diélectrique de protection (326) et les deuxièmes trous d'interconnexion métalliques supérieurs (345) à travers la couche diélectrique de protection (326), les trous d'interconnexion métalliques supérieurs (344) étant en contact avec le premier conducteur d'interconnexion métallique supérieur (322) et les deuxièmes trous d'interconnexion métalliques supérieurs (345) étant en contact avec le deuxième conducteur d'interconnexion métallique supérieur (320) ; et
le pilier métallique (360) sur les trous d'interconnexion métalliques supérieurs (344) et un deuxième pilier métallique (361) sur les deuxièmes trous d'interconnexion métalliques supérieurs (345) ; où :
le pilier métallique (360) s'étend sur une partie du deuxième conducteur d'interconnexion métallique supérieur (320) et le deuxième pilier métallique (361) s'étend sur une partie du premier conducteur d'interconnexion métallique supérieur (322) ;
la couche diélectrique de protection (326) sépare le pilier métallique (360) du deuxième conducteur métallique d'interconnexion (320) et sépare le deuxième pilier métallique (361) du premier conducteur métallique d'interconnexion (322) ; et étant **caractérisée en ce que**
le niveau de trous d'interconnexion ne comprend aucun trou d'interconnexion entre le pilier métallique (360) et le deuxième conducteur d'interconnexion métallique supérieur (320) et ne comprend aucun trou d'interconnexion entre le deuxième pilier métallique (361) et le premier conducteur d'interconnexion métallique supérieur (322).

2. Dispositif à semi-conducteurs selon la revendication 1, dans lequel le pilier métallique (360) a) comprend une sous-couche barrière (358) sous le pilier métallique (360), la sous-couche barrière (358) comprenant un matériau sélectionné dans un groupe constitué de titane, de tantale, de tungstène, de nitrure de titane et de nitrure de tantale ; ou b) comprend un matériau sélectionné dans un groupe constitué de cuivre et de nickel ; ou c) contient un capuchon (362) sur le pilier métallique (360) ; le capuchon (362) comprenant un matériau sélectionné dans un groupe constitué d'étain, de zinc, d'antimoine, de cuivre, d'argent, de bismuth, de plomb et d'indium.

3. Dispositif à semi-conducteurs selon la revendication 1, dans lequel une couche métallique connecte électriquement les trous d'interconnexion métalliques supérieurs (344) au pilier métallique (360), la couche métallique comprenant un matériau sélectionné dans un groupe constitué de cuivre et d'aluminium.

4. Dispositif à semi-conducteurs selon la revendication 1, dans lequel la couche diélectrique de protection (326) comprend a) une première sous-couche (328) sur la couche métallique supérieure, et comprend une deuxième sous-couche (330) sur la première sous-couche (328), où la première sous-couche (328) comprend un matériau sélectionné dans un groupe constitué par le dioxyde de silicium et l'oxynitrure de silicium et la deuxième sous-couche (230) comprend un matériau sélectionné dans un groupe constitué par l'oxynitrure de silicium ; ou b) un matériau diélectrique sélectionné dans un groupe constitué par l'oxynitrure de silicium et le nitrure de silicium.

5. Dispositif à semi-conducteurs selon la revendication 1, dans lequel la couche diélectrique de protection (326) comprend une sous-couche d'arrêt de gravure (324) sur la couche métallique supérieure.

6. Procédé (100) de formation d'un dispositif à semi-conducteurs (300), le procédé comprenant les étapes suivantes :
former (102) un composant semi-conducteur (312) s'étendant dans un matériau semi-conducteur (304) d'un substrat de dispositif (302) ;
former (104) une région d'interconnexion (306) sur le composant semi-conducteur (312), la région d'interconnexion (306) comprenant une couche métallique supérieure ;
former (106) un premier conducteur d'interconnexion métallique supérieur (322) dans la couche métallique supérieure et un deuxième conducteur d'interconnexion métallique supérieur (320) dans la couche métallique supérieure adjacente au premier conducteur d'interconnexion métallique supérieur (322) ;
former (108) une couche diélectrique de protection (326) sur la couche métallique supérieure ;
retirer (110) la couche diélectrique de protection (326) dans un trou d'interconnexion supérieur dans la couche diélectrique de protection (326) afin d'exposer une partie du premier conducteur d'interconnexion métallique supérieur (322) ;
former (112) des trous d'interconnexion métalliques supérieurs (344) dans les ouvertures de trous d'interconnexion supérieurs en contact avec le premier conducteur d'interconnexion métallique supérieur (322) ; et
former (118) un pilier métallique (360) sur les trous d'interconnexion métalliques supérieurs (344) ; où :
le pilier métallique (360) s'étend sur une partie du deuxième conducteur d'interconnexion métallique supérieur (320) ; et
la couche diélectrique de protection (326) sépare le pilier métallique (360) du deuxième conducteur d'interconnexion métallique supérieur (320), le dispositif à semi-conducteur est exempt de connexion électrique directe à travers la couche diélectrique de protection du pilier métallique au deuxième conducteur d'interconnexion métallique supérieur, et la couche diélectrique de protection (326) fournit un support mécanique à la couche métallique supérieure ;
le procédé comprenant en outre les étapes suivantes :
former (112) des deuxièmes trous métalliques supérieurs (345) dans les ouvertures de trous d'interconnexion supérieures en contact avec le deuxième conducteur d'interconnexion métallique supérieur (320), où les trous d'interconnexion métalliques supérieurs (344) et les deuxièmes trous d'interconnexion métalliques supérieurs (345) sont inclus dans un niveau de trous d'interconnexion, le niveau de trous d'interconnexion comprenant les trous d'interconnexion métalliques supérieurs (344) à travers la couche diélectrique de protection (326) et les deuxièmes trous d'interconnexion métalliques supérieurs (345) à travers la couche diélectrique de protection (326) ; et
former (118) un deuxième pilier métallique (361) sur les deuxièmes trous d'interconnexion métalliques supérieurs (345) ; où :
le pilier métallique (360) s'étend sur une partie du deuxième conducteur d'interconnexion métallique supérieur (320) et le deuxième pilier métallique (361) s'étend sur une partie du premier conducteur d'interconnexion métallique supérieur (322) ;
la couche diélectrique de protection (326) sépare le pilier métallique (360) du deuxième conducteur métallique d'interconnexion (320) et sépare le deuxième pilier métallique (361) du premier conducteur métallique d'interconnexion (322) ; et étant **caractérisée en ce que**
le niveau de trous d'interconnexion ne comprend aucun trou d'interconnexion entre le pilier métallique (360) et le deuxième conducteur d'interconnexion métallique supérieur (320) et ne comprend aucun trou d'interconnexion entre le deuxième pilier métallique (361) et le premier conducteur d'interconnexion métallique supérieur (322).

7. Procédé selon la revendication 6, dans lequel la formation (118) d'un pilier métallique (360) comprend a) de former une sous-couche barrière (358) sur le pilier métallique (360), la sous-couche barrière (358) comprenant un matériau sélectionné dans un groupe constitué de titane, de tantale, de tungstène, de nitrure de titane et de nitrure de tantale ; ou b) un matériau sélectionné dans un groupe constitué par le cuivre et le nickel.

8. Procédé selon la revendication 6, dans lequel la formation (118) d'un capuchon de pilier métallique (362) sur le pilier métallique (360) comprend un matériau sélectionné dans un groupe constitué par l'étain, le zinc, l'antimoine, le cuivre, l'argent, le bismuth, le plomb et l'indium.

9. Procédé selon la revendication 6, dans lequel la formation (108) de la couche diélectrique de protection (326) comprend a) de former une première sous-couche (328) sur la couche métallique supérieure, et comprend de former une deuxième sous-couche (330) sur la première sous-couche (328), où la première sous-couche (328) comprend un matériau sélectionné dans un groupe constitué de dioxyde de silicium et d'oxynitrure de silicium et la deuxième sous-couche (330) comprend un matériau sélectionné dans un groupe constitué de silicium ; ou b) de former une couche d'un matériau diélectrique sélectionné dans un groupe constitué d'oxynitrure de silicium et de nitrure de silicium ; ou c) de former une couche de soulagement de contrainte (348) sur la couche métallique supérieure et retirer la couche de soulagement de contrainte (348) dans des zones qui exposent des trous d'interconnexion métalliques supérieurs (344).

10. Procédé selon la revendication 6, comprenant en outre de former (114) une couche de soulagement de contrainte (348) sur le dessus de la couche diélectrique de protection (326), la couche de soulagement de contrainte (348) comprenant un matériau sélectionné parmi le polyimide ou le n-polybenzoxazole.

11. Procédé selon la revendication 6, dans lequel la formation (118) du pilier métallique (360) comprend de former une couche métallique sous pilier métallique (356) qui comprend un matériau sélectionné dans un groupe constitué de cuivre et d'aluminium.
